# EUROPEAN PATENT APPLICATION

(11) **EP 0 747 953 A2**
(43) Date of publication of application: **11.12.1996**
(21) Application number: 96830332.1
(22) Date of filing: 06.06.1996
(51) Int. Cl.: H01L 23/367

(54) **Finning for crossed-flow heat exchangers to be fitted on electronic circuits**

(30) Priority: 07.06.1995 IT AN950030
(71) Applicant: PADA ENGINEERING - S.R.L., Saltara (PS) (IT)
(72) Inventor: Franchini, Fabio, Fano (IT)
(74) Representative: Baldi, Claudio

(57) **Abstract**

This invention concerns finning for crossed-flow heat exchangers mounted on electronic circuits, consisting of a series of staggered transverse rows of vertical fins, characterised by special ratios between the different dimensional values of the thicknesses of each of the above fins, the width of the same and the distance between two adjacent fins.

## Description

This invention concerns finning for crossed-flow heat exchangers mounted on electronic circuits.

It is common knowledge that the heat generated by electronic components must be dispersed in order to ensure a junction temperature which is as low as possible with respect to the maximum operating temperature of the electronic components themselves.

The problem of heat dispersion has in recent years become increasingly important in view of the fact that currently the circuit integration density is increasing continuously with a consequent increase in the thermal flow.

There are currently two different types of heat dissipators for electronic components: the first type consists of finned extruded aluminium surfaces (which are simply finned panels), which are often associated to a fan in order to generate forced convection of the coolant.

The second type of dissipator - known as a "tunnel dissipator" or more appropriately as a "compact crossed-flow exchanger", consists of a box composed of two wide horizontal plates and two vertical walls with numerous vertical fins brazed between the two plates.

The advantage of this type of dissipator is the extremely high density of the fins and their appreciable capacity to interact with the coolant, in other words their capacity to achieve high coefficients of convective thermal exchange with the coolant. These dissipators have numerous transverse metal fins between the two supporting plates.

Each row of fins consists in fact of a single metal strip, bent into a fretted shape, in which a short horizontal section fixed to the bottom supporting plate, a long vertical section whose height is equal to the centre to centre distance between the two supporting horizontal plates and a second short horizontal section - identical to the first - fixed to the upper supporting plate and a second vertical section identical and parallel to the first, are alternated continuously.

It is obvious from the above that the horizontal sections of a similar fretted strip represent connection bridges for the above vertical sections of the same strip, which in turn constitute the actual fins themselves.

It should also be added that in the current state of the art, the fins in exchangers of this kind are generally arranged in a layout known as the "offset strip fin".

This means that the fins forming the first row are arranged next to each other at a regular distance, while the fins of the second row are not aligned to those of the first row, but are placed in a position corresponding to that of the empty spaces between the fins of the first row; the fins of the third row are aligned exactly with those of the first row, while the fins of the fourth row are aligned with those of the second and so on.

Practical experience has however demonstrated that the technique of mounting fins on staggered transverse rows in a casual configuration is not in itself sufficient to ensure an efficient practical result.

The applicant of this patent consequently carried out an in-depth study of the finning for crossed-flow exchangers currently on the market, and has in this way succeeded in identifying the most critical problems and resolving them radically thanks to the invention in question.

For major clarity the description of the invention continues with reference to the drawings which are intended for purposes of illustration and not in a limiting sense, whereby:
- figure 1 illustrates the mouthpiece of a continuous-flow exchanger using internal finning according to the invention;
- figure 2 is a front view of the finning according to the invention used in the device shown in figure 1;
- figure 3 is a top view of the finning illustrated in figure 2.

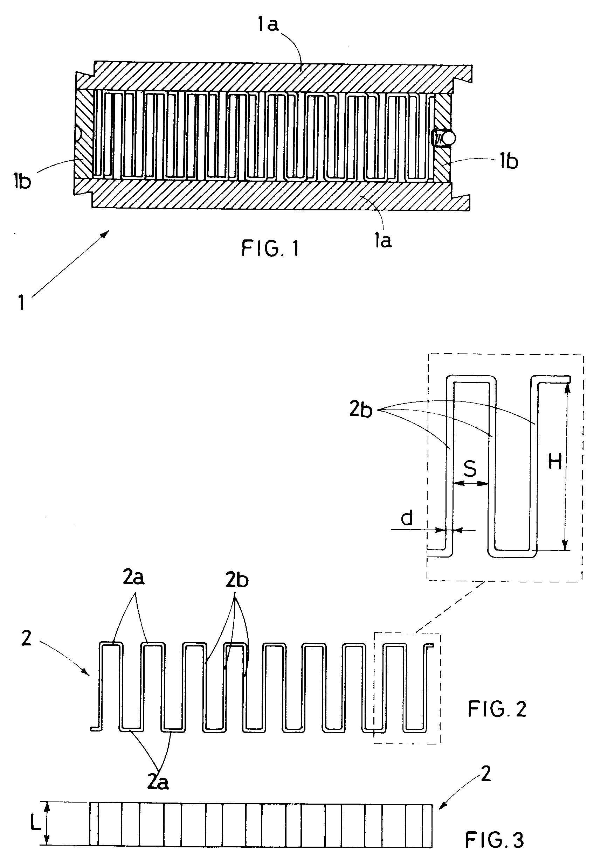

With reference to figure 1, a continuous-flow exchanger (1) consists basically of a box composed by two horizontal walls (1a) and two vertical walls (1b); several transverse rows of vertical fins being brazed between the two horizontal walls (1a).

According to current technology, said transverse rows of fins consist of fretted metal strips identical to that illustrated in figures 2 and 3.

Each of these strips is in fact bent so as to feature short horizontal sections (2a) alternated to vertical fins (2b) for the entire length.

Figure 1 also shows that said fretted strips (2) are mounted in staggered position inside the exchanger (1); in other words, the fins (2b) of the odd rows are staggered with respect to those of the even rows, while the fins of all the even rows are perfectly aligned, just as are all the fins of the odd rows.

As mentioned above, the specific scope of this invention is the configuration of each of said fretted strips housed inside the exchanger (1) with particular reference to the ratios established between the different dimensional values of the various elements of said strip.

With reference to figures 2 and 3 which illustrate the strip according to the invention:
- "H" refers to the height of the cross-section of the air channel inside each tunnel;
- "S" refers to the distance between two adjacent fins (2b);
- "d" refers to the thickness of the fin (2b);
- "L" refers to the width of the fin (2b);
- "Dh" refers to a particular coefficient constituted by the ratio between the value of "H" multiplied by the value of "S", the result being multiplied by 2 and the value of "H" being summed to the value of "S".

These symbols are shown in the following table to illustrate the ratios between the dimensional values of the different elements of the fretted strip (4) considered to be ideal for the proper functioning of a crossed-flow exchanger and which constitute the specific scope of this patent.

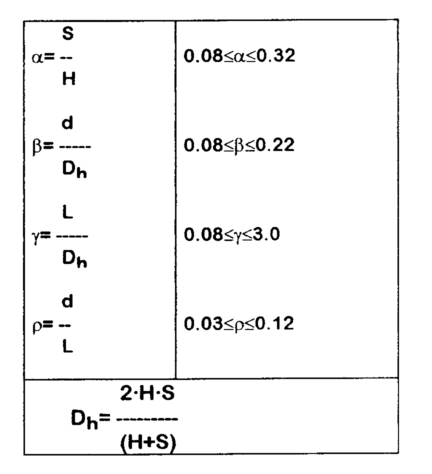

It is important to point out that the application of this inventive idea - namely the above special dimensional ratios - is not necessarily related to the use of a monolithic fretted strip; in fact, even if in the preferred embodiment of the invention described above, the fins (2b) constitute the vertical sections of a fretted monolithic strip, there is nothing to prevent mounting transverse rows of single fins - separated from each other - in the dissipator in question, provided the above dimensional ratios are complied with.

The determining parameters for the proper operation of the fins in question in fact refer to dimensional values which are not necessarily related to the use of a fretted strip.

## Claims

1. A finning for crossed-flow heat exchangers mounted on electronic circuits consisting of a series of staggered transverse rows of vertical fins (2b) characterised in that the thickness (d), the width (L) of each fin (2b) and the distance (S) between two adjacent fins assume values such as to satisfy the following conditions:
